# EUROPÄISCHE PATENTSCHRIFT

(11) **EP 3 879 105 B1**
(45) Veröffentlichungstag und Bekanntmachung des Hinweises auf die Patenterteilung: **23.10.2024**
(21) Anmeldenummer: 21157336.5
(22) Anmeldetag: 16.02.2021
(51) Int. Cl.: F04C 2/10, F04C 11/00, F04C 15/00

(54) **PUMPENEINSATZ UND PUMPENANORDNUNG MIT EINEM SOLCHEN PUMPENEINSATZ**
PUMP INSERT AND PUMP ASSEMBLY COMPRISING SUCH A PUMP INSERT
INSERT DE POMPE ET AGENCEMENT DE POMPE DOTÉ D'UN TEL INSERT DE POMPE

(30) Priorität: 12.03.2020 DE 102020106796
(43) Veröffentlichungstag der Anmeldung: 15.09.2021
(73) Patentinhaber: Schwäbische Hüttenwerke Automotive GmbH, 73433 Aalen (DE)
(72) Erfinder: JÄGGLE, Gerd, 88521 Ertingen (DE); EHRINGER, Michael, 88427 Bad Schussenried (DE); WIEBEL, Georg, 88284 Wolpertswende (DE)
(74) Vertreter: SSM Sandmair

(56) Entgegenhaltungen:
- EP-A1- 3 098 382
- DE-A1- 102013 202 586
- JP-A- 2011 052 682
- JP-A- 2012 097 584
- US-A1- 2012 128 513
- US-A1- 2014 241 917

## Beschreibung

Die Erfindung betrifft einen Pumpeneinsatz zur Anordnung in einem Aufnahmeraum. Der in dem Aufnahmeraum angeordnete Pumpeneinsatz bildet eine Pumpenanordnung. Der Pumpeneinsatz bildet eine Pumpe-Motor-Einheit mit einem Elektromotor zum Antrieb der Pumpe. Die Pumpe und der Elektromotor bilden zusammen eine Einheit. Die Pumpe kann eine Flüssigkeitspumpe, beispielsweise eine Öl- oder Kraftstoffpumpe, sein. Die Pumpe-Motor-Einheit kann beispielsweise einen Hydromotor oder ein Getriebe, wie z.B. ein Fahrzeuggetriebe oder ein Getriebe, beispielsweise ein Achsgetriebe, eines Kraftfahrzeugs, mit Fluid versorgen, insbesondere zur Schmierung und/oder Kühlung und/oder Betätigung von Komponenten des Getriebes. Sie kann beispielsweise mit dem Getriebe eine Getriebeeinheit bilden oder an einem Getriebe befestigt sein oder zumindest strömungstechnisch, insbesondere fluidkommunizierend, mit dem Getriebe verbunden sein. Grundsätzlich kann mit der Pumpe-Motor-Einheit ein Verbrennungsmotor, insbesondere ein Verbrennungsmotor eines Kraftfahrzeugs, mit Fluid versorgt werden, insbesondere zur Schmierung und/oder Kühlung.

Pumpen dieser Bauweise sind beispielsweise aus der EP 3 081 741 A2 bekannt. Ferner sind Pumpen bekannt, die elektromotorisch angetrieben werden.

Die US 2014/0241917 A1 beschreibt eine elektrisch betriebene Ölpumpe und eine hydraulische Druckversorgungseinrichtung, die beispielsweise in einem Getriebe eines Fahrzeugs eingebaut sind. Ein Vorsprung erstreckt sich axial von einer Stirnwand in eine Abströmpassage des Getriebegehäuses. Ein ähnliches Konzept wird in der DE 10 2013 2025 586 A1 beschrieben.

Eine Pumpvorrichtung mit einem Elektromotor ist ferner aus der EP 3 098 382 A1 bekannt.

Der Erfindung liegt nach einem Aspekt die Aufgabe zugrunde, einen Pumpeneinsatz und eine Pumpenanordnung bereitzustellen, bei der das thermische Management verbessert wird.

Die Aufgabe wird mit der Pumpenanordnung nach Anspruch 1 gelöst. Vorteilhafte Weiterbildungen ergeben sich aus den abhängigen Ansprüchen, der Beschreibung und den Figuren.

Eine erfindungsgemäße Pumpenanordnung, welche durch die Merkmalskombination des Anspruchs 1 definiert wird, umfasst ein Aufnahmegehäuse, welches einen, insbesondere topfförmigen, Aufnahmeraum mit einer Stirnwand und einer Umfangswand bildet, und einen Pumpeneinsatz, der zumindest teilweise in dem Aufnahmeraum angeordnet ist oder in dem Aufnahmeraum angeordnet werden kann. Der Aufnahmeraum kann an einem Ende von der Stirnwand verschlossen sein, die hierzu beispielsweise an die Umfangswand angrenzt. An einem Ende, insbesondere dem Ende, welches der Stirnwand gegenüberliegt, kann der Aufnahmeraum von dem Pumpeneinsatz, insbesondere einer Montagestruktur des Pumpeneinsatzes, verschlossen sein. Insbesondere kann der Aufnahmeraum nach außen hin abgedichtet sein, beispielsweise mittels einer Dichtung oder einem Dichtelement, welches zwischen dem Aufnahmegehäuse und dem Pumpeneinsatz, insbesondere der Montagestruktur des Pumpeneinsatzes, angeordnet sein kann.

Die Pumpe weist eine Pumpenkammer und ein um eine Drehachse drehbares Förderelement auf, welches in der Pumpenkammer angeordnet ist. Die Pumpe kann als Fluidpumpe, insbesondere als Flüssigkeitspumpe, ausgebildet sein. Beispielsweise kann die Pumpe eine Zahnradpumpe, insbesondere eine Innenzahnradpumpe oder eine Außenzahnradpumpe, eine Drehschieberpumpe, eine Flügelzellenpumpe oder eine Pendelschieberpumpe sein. Solche Pumpen weisen einen drehbaren Rotor auf, der hierin, um Verwechslungen mit dem Rotor des später beschriebenen Elektromotors zu vermeiden, als Förderelement oder als erstes Förderelement bezeichnet wird. Die Pumpe ist konfiguriert, Fluid von einem Einlass oder Einlasskanal, insbesondere über die Pumpenkammer, zu einem Auslass oder Auslasskanal zu fördern. Der Einlass kann beispielsweise den Einlasskanal, über den Fluid zu der Pumpenkammer hinströmen kann, und der Auslass kann den Auslasskanal, über den Fluid von der Pumpenkammer abströmen kann, umfassen. Der Einlass bzw. der Einlasskanal und der Auslass bzw. der Auslasskanal können von einem Pumpengehäuse des Pumpeneinsatzes, welches einteilig oder mehrteilig sein kann, gebildet sein.

Die Pumpenkammer kann von dem Pumpengehäuse gebildet, insbesondere eingefasst oder begrenzt sein. Beispielsweise kann der Gehäusegrundkörper einen Hohlraum bilden, welcher der Pumpenkammer entspricht und auf einer Seite von einem Gehäusedeckel abgedeckt sein kann. Auf einer (ersten) Stirnseite der Pumpenkammer kann das Förderelement, insbesondere das erste Förderelement, einen Dichtspalt mit dem Gehäusegrundkörper und auf der anderen (zweiten) Stirnseite der Pumpenkammer kann das Förderelement, insbesondere das erste Förderelement, einen Dichtspalt mit dem Gehäusedeckel bilden. Alternativ kann auf der (ersten) Stirnseite der Pumpenkammer das Förderelement, insbesondere das erste Förderelement, einen Dichtspalt mit einem ersten Gehäusedeckel und auf der anderen (zweiten) Stirnseite der Pumpenkammer kann das Förderelement, insbesondere das erste Förderelement, einen Dichtspalt mit einem weiteren oder zweiten Gehäusedeckel, bilden.

Das Förderelement, insbesondere das erste Förderelement, ist relativ zu dem Gehäuse, insbesondere zu dem Gehäusegrundkörper und/oder zu dem ersten und/oder zweiten Gehäusedeckel um eine Drehachse drehbar oder dreht sich im Betrieb um diese Drehachse.

Beispielsweise kann in der Pumpenkammer mindestens ein weiteres, beispielsweise ein zweites, Förderelement angeordnet sein. Beispielsweise kann das erste Förderelement ein Ritzel oder ein Zahnrad mit einer Außenverzahnung sein, wobei das zweite Förderelement ein Hohlrad mit einer Innenverzahnung sein kann, welche in einem Eingriff mit der Außenverzahnung des ersten Förderelements ist. Der Außendurchmesser des ersten Förderelements kann kleiner als der Innendurchmesser des zweiten Förderelements sein. Beispielsweise kann die Außenverzahnung des ersten Förderelements eine geringere Zähnezahl aufweisen als die Innenverzahnung des zweiten Förderelements. Das zweite Förderelement kann um eine weitere Drehachse drehbar sein, welche zu der Drehachse des ersten Förderelements parallel versetzt sein kann oder ist. Eine Drehung des ersten Förderelements bewirkt eine Drehung des zweiten Förderelements um eine weitere Drehachse, wobei die Drehzahl des zweiten Förderelements geringer ist als die Drehzahl des ersten Förderelements.

Der Pumpeneinsatz weist einen Elektromotor auf, der beispielsweise stirnseitig an der Pumpe angeordnet sein kann. Der Elektromotor umfasst einen um die Drehachse drehbaren Rotor und einen Stator. Beispielsweise kann der Stator des Elektromotors den Rotor des Elektromotors zumindest teilweise oder vollständig umgeben. Insbesondere kann der Elektromotor als Innenläufermotor ausgebildet sein. Alternativ kann der Rotor den Stator zumindest teilweise umgeben. Insbesondere kann der Elektromotor als Außenläufermotor ausgebildet sein. Beispielsweise kann der Stator mehrere Spulen, insbesondere Statorspulen, aufweisen. Die Spulen sind beispielsweise als mehrphasiges, insbesondere dreiphasiges, System ausgebildet.

Jede Phase kann mehrere Spulen umfassen. Die Spulen bzw. jede Phase können durch eine geeignete Schaltung oder Steuerung so angesteuert werden, dass die Spulen ein in Drehrichtung des Rotors wanderndes magnetisches Feld erzeugen, welches den Rotor veranlasst, sich um seine Drehachse zu drehen. Der Rotor kann beispielsweise einen oder mehrere Magnete, insbesondere Permanentmagnete, aufweisen, welche mit dem magnetischen Feld, welches durch die Spulen erzeugt wird, wechselwirkt. Insbesondere kann der Elektromotor als bürstenloser Gleichstrommotor ausgebildet sein.

Der Pumpeneinsatz weist ferner eine um die Drehachse des Rotors und/oder des (ersten) Förderelements drehbar gelagerte Antriebswelle auf, wobei der Rotor des Elektromotors und das (erste) Förderelement der Pumpe über die Antriebswelle derart verbunden sind, dass eine Drehung des Rotors eine Drehung des Förderelements bewirkt.

Die Antriebswelle kann beispielsweise einteilig sein und/oder sich von dem Rotor bis zu dem (ersten) Förderelement erstrecken. Insbesondere kann sich die Antriebswelle durch den Rotor und/oder durch die Pumpenkammer oder das erste Förderelement hindurch erstrecken.

Der Pumpeneinsatz kann eine, beispielsweise plattenförmige, Montagestruktur aufweisen, mit welcher der Pumpeneinsatz an dem Aufnahmegehäuse eine Wärmebrücke bildend befestigbar ist. Beispielsweise kann die Montagestruktur einen Flansch bilden, der sich an dem Aufnahmegehäuse abstützt. Die Montagestruktur, insbesondere der Flansch der Montagstruktur, kann mit einem oder mehreren Befestigungsmitteln, beispielsweise Schraubenbolzen, an dem Aufnahmegehäuse befestigt sein. Beispielsweise kann das Aufnahmegehäuse ein Innengewinde aufweisen, in welches ein Außengewinde des Befestigungsmittels eingeschraubt ist. Beispielsweise kann die Montagestruktur, insbesondere deren Flansch, zwischen dem Aufnahmegehäuse und einem Kopf des Befestigungsmittels oder einer auf dem Befestigungsmittel angeordneten Schraubenmutter eingeklemmt sein oder werden.

Die Montagestruktur kann beispielsweise aus Metall oder einer Metalllegierung gebildet sein. Beispielsweise kann das Metall Aluminium oder die Metalllegierung auf einer Aluminium- oder Magnesiumbasis basieren. Das Aufnahmegehäuse und die Montagestruktur können aus dem gleichen Metall oder der gleichen Metalllegierung oder aus einem unterschiedlichen Metall oder einer unterschiedlichen Metalllegierung ausgebildet sein.

Die Montagestruktur kann einen Deckel bilden, der den Aufnahmeraum abschließt. Alternativ oder zusätzlich kann zwischen der Montagestruktur und dem Aufnahmegehäuse eine, insbesondere ringförmige, Dichtung angeordnet ist, welche den Aufnahmeraum nach außen, d.h. zur Umgebung hin abdichtet. Die insbesondere ringförmige Dichtung kann dichtend an einer Stirnfläche des Flansches oder der Montagestruktur und einer dazu gegenüberliegenden Stirnfläche des Aufnahmegehäuses anliegen. Beispielsweise kann die Dichtung in zumindest einer der einander gegenüberliegenden Stirnflächen gebildeten Vertiefung angeordnet sein und an einer Fläche der Vertiefung dichtend anliegen.

Der Pumpeneinsatz kann eine Steuerungselektronik für die Steuerung des Elektromotors aufweisen. Die Steuerungselektronik kann auf einer von dem Elektromotor abgewandten Seite der Montagestruktur und /oder außerhalb des Aufnahmeraums angeordnet sein. Beispielsweise kann die Montagestruktur zwischen dem Elektromotor und der Steuerungselektronik angeordnet sein. Beispielsweise kann die Montagestruktur den Elektromotor oder dessen Motorraum stirnseitig abschließen. Insbesondere kann die Montagestruktur den Motorraum, der von dem Stator zumindest teilweise eingefasst wird, stirnseitig begrenzen. Insbesondere können der Stator und/oder der Rotor zwischen der Montagestruktur und der Pumpe angeordnet sein. Die Pumpe oder das Pumpengehäuse kann den Motorraum auf der der Montagestruktur abgewandten Seite stirnseitig begrenzen.

Zwischen der Steuerungselektronik und der Montagestruktur kann eine Wärmebrücke gebildet sein, über die ein Wärmetransport von der Steuerungselektronik zu der Montagestruktur bewirkbar ist. Insbesondere ist die Wärmebrücke so angepasst, dass der Wärmetransport ausreicht, die von der Steuerungselektronik im Betrieb erzeugte Wärme wesentlich, insbesondere größtenteils, über die Montagestruktur oder in die Montagestruktur abzuführen.

Beispielsweise kann die Montagestruktur Kühlrippen aufweisen, welche die von der Steuerungselektronik über die Wärmebrücke in die Montagestruktur abgeführte Wärmeenergie abgeben kann. Beispielsweise können die Kühlrippen so an der Montagestruktur gebildet sein, dass die Wärmeenergie an die Umgebung, d. h. einen Bereich außerhalb des Aufnahmeraums, beispielsweise an die Umgebungsluft, abgegeben werden kann. Alternativ oder zusätzlich können Kühlrippen der Montagestruktur so angeordnet sein, dass sie Wärmeenergie in den Motorraum oder den Aufnahmeraum, beispielsweise an ein Fluid oder eine Flüssigkeit, das oder die darin enthalten ist, abgeben können. Beispielsweise kann der Pumpeneinsatz oder die Pumpenanordnung so ausgebildet sein, dass Fluid durch den Pumpenraum und/oder den Aufnahmeraum strömt und dabei eine Oberfläche, beispielsweise der Kühlrippen, der Montagestruktur überstreichen kann, wodurch Wärmeenergie aus der Montagestruktur in das Fluid abführbar ist.

Alternativ oder zusätzlich kann Wärmeenergie aus der Montagestruktur in das Aufnahmegehäuse abgeleitet oder übertragen werden, insbesondere mittels einer zwischen der Montagestruktur und dem Aufnahmegehäuse gebildeten Wärmebrücke, wie später noch beschrieben wird.

Zwischen der Steuerungselektronik und der Montagestruktur kann mindestens ein Wärmeleitelement, insbesondere Wärmeleitpaste oder ein Wärmeleitpad, angeordnet sein. Beispielsweise kann das mindestens eine Wärmeleitelement zumindest in den Bereichen zwischen der Steuerungselektronik und der Montagestruktur angeordnet sein, in der die Steuerungselektronik Bauteile aufweist, die während des Betriebs einer Wärmeabfuhr oder Kühlung bedürfen.

Die Steuerungselektronik kann zumindest teilweise auf einem Trägerelement, beispielsweise einer Leiterplatte, angeordnet sein. In dem Bereich einer oder mehrerer Komponenten oder Bauteile der Steuerungselektronik kann ein oder jeweils ein Wärmeleitelement zwischen der Komponente und der Montagestruktur angeordnet sein. Alternativ oder zusätzlich können ein oder mehrere Wärmeleitelemente zwischen dem Trägerelement und der Montagestruktur angeordnet sein. Allgemein ist bevorzugt, dass das Wärmeleitelement an einer Oberfläche der Montagestruktur und einer Oberfläche der zu kühlenden Komponente der Steuerungselektronik oder der Leiterplatte anliegt.

Durch das Wärmeleitelement wird der Wärmeübergang zwischen der Steuerungselektronik und der Montagestruktur ermöglicht oder zumindest verbessert.

Der Pumpeneinsatz kann in Weiterbildungen ein Elektronikgehäuse, welches beispielsweise aus Metall, einer Metalllegierung oder aus Kunststoff gebildet ist, aufweisen. Das Elektronikgehäuse kann an der Montagestruktur befestigt sein und/oder einen Innenraum einfassen. Der Innenraum kann in Bezug auf die Außenseite bzw. die Umgebung, beispielsweise mittels einer Dichtung, insbesondere einem Dichtring, die zwischen dem Elektronikgehäuse und der Montagestruktur angeordnet ist und insbesondere an diesen dichtend anliegt, abgedichtet sein. Die Steuerungselektronik kann in dem Elektronikgehäuse, insbesondere in dem Innenraum, angeordnet sein oder von dem Elektronikgehäuse umgeben sein. Die Steuerungselektronik, insbesondere das Trägerelement, kann, insbesondere in dem Innenraum, zwischen der Montagestruktur und dem Elektronikgehäuse angeordnet sein. Das Elektronikgehäuse kann beispielsweise dazu vorgesehen sein, die Steuerungselektronik vor äußeren Einflüssen zu schützen.

Das Elektronikgehäuse, wie z. B. ein oder mehrere Niederhalteelemente des Elektronikgehäuses, können das Trägerelement, insbesondere eine Leiterplatte, auf dem die Steuerungselektronik zumindest teilweise angeordnet ist, zu der oder an die Montagestruktur drücken. Beispielsweise kann das Elektronikgehäuse oder können dessen Niederhalteelemente an dem Trägerelement anliegen. Beispielsweise kann das Elektronikgehäuse in einem oder mehreren Bereichen an dem Trägerelement, beispielsweise mittels jeweils eines Niederhalteelements, anliegen, wobei die Bereiche an den Rändern und/oder zwischen den Rändern liegen können. Durch das mindestens eine Niederhalteelement wird bewirkt, dass das Trägerelement oder Komponenten der Steuerungselektronik gegen die Montagestruktur oder das oder die Wärmeleitelemente gedrückt werden, wodurch der Wärmeübergang zwischen Steuerungselektronik und Montagestruktur verbessert wird.

Beispielsweise können eines oder mehrere der Niederhalteelemente stiftförmig, rippenförmig, stufenförmig oder dergleichen sein. Insbesondere kann das mindestens eine Niederhalteelement monolithisch mit dem Elektronikgehäuse gebildet sein, beispielsweise dadurch, dass das Elektronikgehäuse mit dem mindestens einen Niederhalteelement aus Kunststoff im Spritzgussverfahren oder aus einer Metalllegierung im Druckgussverfahren hergestellt worden ist. Das mindestens eine Niederhalteelement kann von einer zum Trägerelement weisenden Stirnseite des Elektronikgehäuses zu dem Trägerelement hin, beispielsweise stiftförmig, abragen und an dem Trägerelement anliegen.

Die Montagestruktur kann in Weiterbildungen einen Durchgang oder mindestens einen Durchgang aufweisen, durch welchen sich mindestens ein Kontaktelement erstreckt, welches die Elektronikeinheit und mindestens eine Spule des Stators elektrisch kontaktiert. Das Kontaktelement kann Teil der Elektronikeinheit sein und von der Elektronikeinheit oder dem Trägerelement der Elektronikeinheit durch den Durchgang hindurch in den Motorraum ragen. Alternativ kann das mindestens eine Kontaktelement an dem Stator gebildet sein, und von dem Stator durch den Durchgang hindurch zur Elektronikeinheit ragen. Für das Kontaktelement ist ein Kontaktgegenelement, welches entsprechend von dem Stator oder von der Elektronikeinheit gebildet ist und zur Bildung einer Steckverbindung mit dem Kontaktelement kontaktierbar und/oder zusammensteckbar ist, vorgesehen. Der Durchgang, durch den sich das mindestens eine Kontaktelement erstreckt, kann beispielsweise mittels einer Dichtmasse oder Vergussmasse, einer Dichtung oder dergleichen abgedichtet sein, so dass der Motorraum und die Steuerungselektronik mediendicht voneinander getrennt sind.

In Ausführungen kann das Pumpengehäuse, beispielsweise der (zweite) Gehäusedeckel, zumindest zwischen dem Elektromotor und dem Pumpenraum ein (zweites) Drehlager aufweisen, über welches sich die Antriebswelle um die Drehachse drehbar an dem Pumpengehäuse abstützt.

Optional kann das Pumpengehäuse, beispielsweise der (erste) Gehäusedeckel, ein weiteres, (erstes) Drehlager, insbesondere auf der Seite des Pumpenraums, welche dem Motorraum abgewandt ist, aufweisen, über welches sich die Antriebswelle um die Drehachse drehbar an dem Pumpengehäuse abstützt. Alternativ oder zusätzlich kann sich die Antriebswelle um die Drehachse drehbar an der Montagestruktur abstützen, insbesondere mittels eines weiteren (dritten) Drehlagers. Die hierin beschriebenen Drehlager können beispielsweise Gleit- oder Wälzlager sein. Für das oder die Drehlager, über das oder die sich die Antriebswelle an dem Pumpengehäuse abstützt, können Gleitlager bevorzugt sein. Das Drehlager, über welches sich die Antriebswelle an der Montagestruktur abstützt, kann beispielsweise ein Gleitlager oder ein Wälzlager sein.

In Weiterbildungen kann zwischen der Montagestruktur und dem Aufnahmegehäuse eine Wärmebrücke gebildet sein, über die ein Wärmetransport von der Montagestruktur zu dem Aufnahmegehäuse bewirkbar ist. Beispielsweise kann die Wärmebrücke zwischen dem Flansch, mit dem die Montagestruktur und somit der Pumpeneinsatz an dem Aufnahmegehäuse befestigt ist, und dem Aufnahmegehäuse gebildet sein.

Beispielsweise kann die Montagestruktur an dem Aufnahmegehäuse unmittelbar anliegen. Alternativ kann zwischen der Montagestruktur und dem Aufnahmegehäuse ein Wärmeleitelement, insbesondere Wärmeleitpaste oder ein Wärmeleitpad, angeordnet sein. Hierdurch wird im Vergleich zu Ausführungen, bei denen die Montagestruktur direkt an dem Aufnahmegehäuse anliegt, die Wärmeübertragung zwischen der Montagestruktur und dem Aufnahmegehäuse verbessert.

Beispielsweise kann die zwischen der Montagestruktur des Pumpeneinsatzes und dem Aufnahmegehäuse gebildete Wärmebrücke, die Montagestruktur und die Wärmebrücke, die zwischen der für die Steuerung des Elektromotors ausgebildeten Steuerungselektronik und der Montagestruktur gebildet ist, so aufeinander abgestimmt sein, dass die während des Betriebs des Elektromotors in der Steuerungselektronik entstehende Wärme zumindest größtenteils über die zwischen der Steuerungselektronik und der Montagestruktur gebildete Wärmebrücke, die Montagestruktur und die zwischen der Montagestruktur und dem Aufnahmegehäuse gebildete Wärmebrücke in das Aufnahmegehäuse abgeführt wird oder abführbar ist. Hierdurch lässt sich vorteilhaft die während des Betriebs in der Steuerungselektronik oder einzelnen Komponenten davon entstehende Wärme in das Aufnahmegehäuse abführen, wodurch ein vorteilhaftes Wärmemanagement erreicht wird.

In Ausführungsformen kann der Pumpeneinsatz so ausgebildet sein, dass Fluid, insbesondere Leckagefluid aus dem Pumpenraum durch zumindest eines der Drehlager, mit dem sich die Antriebswelle drehbar abstützt, in den Motorraum abführbar ist. Beispielsweise kann der Pumpeneinsatz so ausgebildet sein, dass Leckagefluid aus der Pumpenkammer durch das zwischen der Pumpenkammer und dem Elektromotor gebildete Drehlager, welches beispielsweise als Gleitlager ausgebildet ist, in den Motorraum abgeführt werden kann. In Ausführungsformen kann der Pumpeneinsatz so ausgebildet sein, dass Leckagefluid aus der Pumpenkammer durch das an der dem Elektromotor abgewandten Seite der Pumpenkammer angeordnete Drehlager, beispielsweise Gleitlager, unmittelbar in den Aufnahmeraum oder in den Motorraum abführbar ist. Alternativ oder zusätzlich kann die Antriebswelle einen Durchgang aufweisen, durch den das Leckagefluid in den Motorraum abführbar ist.

Der Pumpeneinsatz, beispielsweise die Montagestruktur oder der Stator oder das Pumpengehäuse, kann einen Motorraumauslass, der beispielsweise kanalförmig ausgebildet sein kann, aufweisen, welcher den Motorraum mit der Außenseite des Pumpeneinsatzes bzw. dem Aufnahmeraum fluidkommunizierend verbindet. Der Motorraumauslass kann an die Außenseite, insbesondere den Außenumfang, des Pumpeneinsatzes bzw. in den Aufnahmeraum münden. Der Motorraum wird von dem Stator umfangsseitig umgeben. Durch die fluidkommunizierende Verbindung des Motorraums mit dem Außenumfang des Pumpeneinsatzes bzw. dem Aufnahmeraum ist der Pumpeneinsatz ausgebildet, dass Fluid über den Motorraumauslass aus dem Motorraum an den Außenumfang des Pumpeneinsatzes oder den Aufnahmeraum abführbar ist. Insbesondere kann dadurch das aus der Pumpenkammer in den Motorraum abgeführte Leckagefluid an den Außenumfang des Pumpeneinsatzes oder in den Aufnahmeraum zwischen dem Pumpeneinsatz und der Umfangswand des Aufnahmeraums abgeführt werden.

In Ausführungen kann der Motorraumauslass oder Motorraumauslasskanal seitlich, d. h. umfangsseitig, an dem Pumpeneinsatz angeordnet sein. Alternativ oder zusätzlich kann der Motorraumauslass mit einer Motorraumauslassöffnung zu der Umfangswand des Aufnahmeraums, die von dem Aufnahmegehäuse gebildet wird, hingewandt an die Außenseite des Pumpeneinsatzes, insbesondere der Montagestruktur, des Stators oder des Pumpengehäuses, münden.

Das Aufnahmegehäuse kann einen Abführkanal aufweisen, der in den Aufnahmeraum mündet und durch oder über den Fluid aus dem Aufnahmeraum, insbesondere zu einem Vorratsbehälter hin, abführbar ist. Hierdurch ist die Pumpenanordnung ausgebildet, Fluid, welches während des Betriebs aus dem Motorraum über den Motorraumauslass in den Aufnahmeraum abgeführt wird, aus dem Aufnahmeraum, beispielsweise zu dem Vorratsbehälter, abzuführen.

In Ausführungen kann der Pumpeneinsatz einen Einlass, der ausgebildet ist, der Pumpenkammer Fluid zuzuführen und/oder einen Auslass, der angepasst ist, aus der Pumpenkammer Fluid abzuführen, aufweisen. Insbesondere kann der Aufnahmeraum in Bezug auf den Einlass und den Auslass abgedichtet sein, beispielsweise mittels einem oder mehreren Dichtelementen. Der Einlass und der Auslass können, insbesondere mittels des mindestens einen Dichtelements, in Bezug zueinander abgedichtet sein.

Der Pumpeneinsatz kann den Einlass und den Auslass bevorzugt auf der Seite, insbesondere Stirnseite, aufweisen, welche zu der Stirnwand des Aufnahmeraums weist. Der Einlass kann von einem Einlasskanal gebildet sein, der mit einer Öffnung zu der Stirnseite des Pumpeneinsatzes, welche zu der Stirnwand des Aufnahmeraums weist, weist. Die Einlassöffnung und eine Öffnung eines von dem Aufnahmegehäuse gebildeten Zuführkanals können zueinanderweisend gegenüberliegen.

Der Auslass kann von einem Auslasskanal gebildet sein, der mit einer zu der Stirnwand des Aufnahmeraums weisenden Öffnung zu der Stirnseite des Pumpeneinsatzes weist. Die Auslassöffnung und eine Öffnung eines von dem Aufnahmegehäuse gebildeten Abströmkanals können zueinanderweisend gegenüberliegen.

Das Aufnahmegehäuse kann den Zuführkanal, der mit dem Einlass des Pumpeneinsatzes fluidkommunizierend verbunden ist, und den Abströmkanal, der mit dem Auslass des Pumpeneinsatzes fluidkommunizierend verbunden ist, aufweisen. Insbesondere kann das Aufnahmegehäuse den Zuführkanal und den Abströmkanal an seiner Stirnwand, d. h. der Stirnwand, zu der die Seite des Pumpeneinsatzes weist, welche den Einlass und/oder den Auslass aufweist, bilden.

Die Pumpenanordnung kann ein, beispielsweise rohrförmiges, Verbindungselement, welches zwischen dem Zuführkanal und dem Einlass angeordnet ist und diese fluidkommunizierend verbindet, aufweisen. Alternativ oder zusätzlich kann die Pumpenanordnung ein, beispielsweise rohrförmiges, Verbindungselement, welches zwischen dem Abströmkanal und dem Auslass angeordnet ist und diese fluidkommunizierend verbindet, aufweisen. Vorzugsweise ist das rohrförmige Verbindungselement ein von dem Pumpengehäuse, insbesondere dem (ersten) Gehäusedeckel und dem Aufnahmegehäuse separates Teil. Ein solches rohrförmiges Verbindungselement ist oder wird in den Einlass eingesteckt und ein weiteres rohrförmiges Verbindungselement ist oder wird in den Auslass eingesteckt. Beispielsweise kann das mindestens eine rohrförmige Verbindungselement, beispielsweise reibschlüssig, an dem Pumpengehäuse gehalten werden. Insbesondere kann ein Dichtelement vorgesehen sein, welches einen Dichtspalt zwischen dem rohrförmigen Verbindungselement und dem Einlass bzw. dem rohrförmigen Verbindungselement und dem Auslass, abdichtet.

Für die Montage der Pumpenanordnung kann jeweils ein Verbindungselement für den Einlass und den Auslass an dem Pumpeneinsatz angeordnet werden oder sein. Der mit den Verbindungselementen ausgestattete Pumpeneinsatz ist als Einheit handhabbar und kann in den Aufnahmeraum des Aufnahmegehäuses eingesetzt werden. Beispielsweise können während des Einsetzens des Pumpeneinsatzes die fluidkommunizierende Verbindung zwischen dem Zuführkanal und dem Einlass und die fluidkommunizierende Verbindung zwischen dem Abströmkanal und dem Auslass, insbesondere durch axiales Einstecken der Verbindungselemente in den Zuführkanal bzw. Abströmkanal, hergestellt werden.

Das Verbindungselement, welches den Zuführkanal und den Einlass fluidkommunizierend verbindet, kann beispielsweise in den Zuführkanal einsteckbar sein oder eingesteckt sein. Ein Dichtelement, insbesondere Dichtring, kann zwischen dem Verbindungselement, insbesondere einer Außenumfangsfläche des Verbindungselements und dem Zuführkanal, insbesondere einer Innenumfangsfläche des Zuführkanals angeordnet sein und den Zuführkanal in Bezug auf den Aufnahmeraum abdichten. Das Dichtelement kann an der Außenumfangsfläche und der Innenumfangsfläche dichtend anliegen. Insbesondere kann sich das Verbindungselement, welches den Zuführkanal mit dem Einlass verbindet, durch den Aufnahmeraum erstrecken.

Das Verbindungselement, welches den Abströmkanal und den Auslass fluidkommunizierend verbindet, kann beispielsweise in den Abströmkanal einsteckbar sein oder eingesteckt sein. Ein Dichtelement, insbesondere Dichtring, kann zwischen dem Verbindungselement, insbesondere einer Außenumfangsfläche des Verbindungselements und dem Abströmkanal, insbesondere einer Innenumfangsfläche des Abströmkanals angeordnet sein und den Abströmkanal in Bezug auf den Aufnahmeraum abdichten. Das Dichtelement kann an der Außenumfangsfläche und der Innenumfangsfläche dichtend anliegen. Insbesondere kann sich das Verbindungselement, welches den Abströmkanal mit dem Auslass verbindet, durch den Aufnahmeraum erstrecken.

Allgemein bevorzugt ist, dass der Stator des Pumpeneinsatzes zumindest einen Teil des Außenumfangs oder die Außenseite des Pumpeneinsatzes bildet und/oder den Aufnahmeraum begrenzt. Mit anderen Worten weist der Pumpeneinsatz in bevorzugten Ausführungen kein Außengehäuse auf.

Die Erfindung wurde anhand mehrerer Ausführungen und Beispiele beschrieben. Im Folgenden wird die Erfindung anhand von Figuren beschrieben. Es zeigen:
- Figur 1: eine Explosionsdarstellung eines erfindungsgemäßen Pumpeneinsatzes,
- Figur 2: eine perspektivische Darstellung des Pumpeneinsatzes aus Figur 1,
- Figur 3: eine Pumpenanordnung mit einem Aufnahmegehäuse und dem darin eingesetzten Pumpeneinsatz nach den Figuren 1 und 2,
- Figur 4: eine Montagestruktur des Pumpeneinsatzes und
- Figur 5: einen Teilschnitt der Montagestruktur und des Stators, der einen Motorraumauslass zeigt.

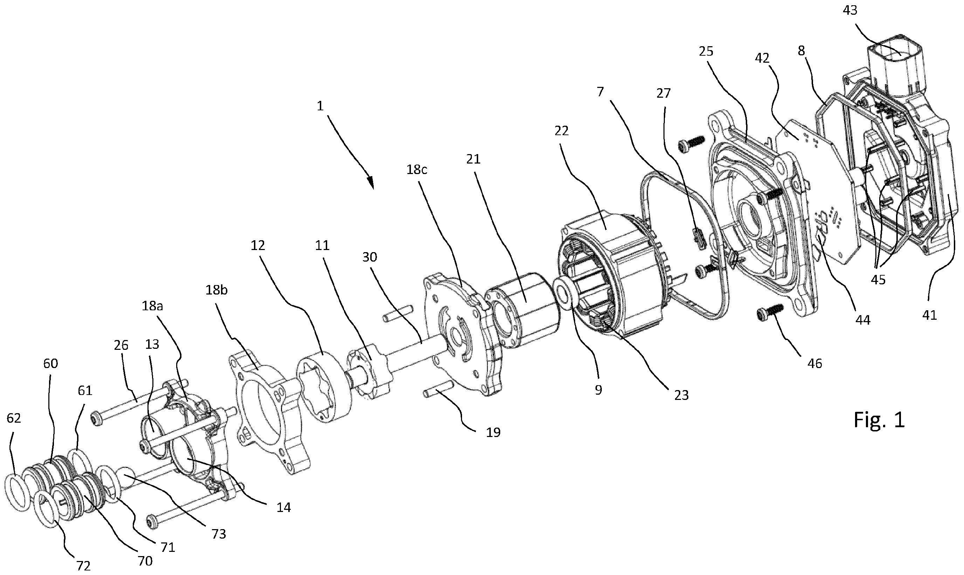

Der in den Figuren 1 bis 3 gezeigte Pumpeneinsatz 1 weist eine Pumpe 10 und einen Elektromotor 20, der stirnseitig an der Pumpe 10 oder einem Pumpengehäuse 18 der Pumpe 10 angeordnet oder befestigt ist, auf. Die Pumpe 10 weist ein Pumpengehäuse 18 auf, welches einen Gehäusegrundkörper 18b und einen stirnseitig daran befestigten ersten Gehäusedeckel 18a und einen weiteren, zweiten Gehäusedeckel 18c aufweist. Der Gehäusedeckel 18c ist an der Stirnseite des Gehäusegrundkörpers 18b angebracht, die zu dem Elektromotor 20 weist. Der Gehäusedeckel 18c ist zwischen dem Elektromotor 20, insbesondere einem Stator 22 des Elektromotors 20, und dem Gehäusegrundkörper 18b angeordnet. Auf der anderen Stirnseite des Gehäusegrundkörpers 18b, d. h. der Stirnseite, die von dem Elektromotor 20 abgewandt ist, ist der Gehäusedeckel 18a angebracht. In dem gezeigten Beispiel ist der Gehäusegrundkörper 18b zwischen den Gehäusedeckeln 18a, 18b angeordnet. Alternativ zu der gezeigten Ausführung kann entweder der Gehäusedeckel 18a oder der Gehäusedeckel 18c mit dem Gehäusegrundkörper 18b einteilig, d.h. monolithisch gebildet sein. Die Gehäusedeckel 18a, 18b und der Gehäusegrundkörper 18b können zueinander mittels mindestens eines Zentrierstifts 19 zentriert oder lagerichtig positioniert sein.

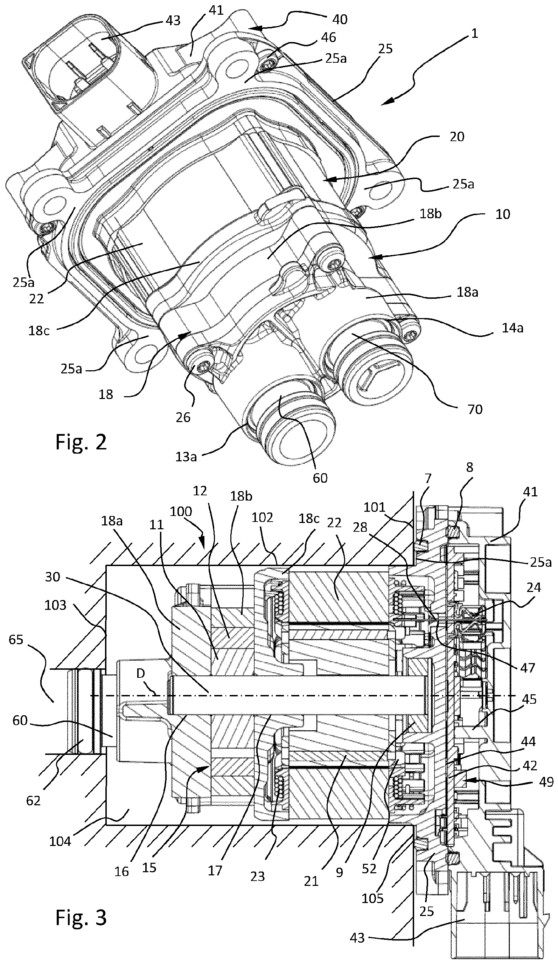

Das Pumpengehäuse 18 bildet, wie beispielsweise aus der Figur 3 ersichtlich ist, eine Pumpenkammer 15, die eine zylindrische Innenumfangswand aufweist. Die Pumpenkammer 15 wird auf einer Stirnseite von dem Gehäusedeckel 18a und auf der anderen Stirnseite von dem Gehäusedeckel 18c axial begrenzt. In der Pumpenkammer 15 sind ein erstes Förderelement 11 und ein zweites Förderelement 12 angeordnet. Das erste Förderelement 11 ist als Außenzahnrad gebildet und mit einer Antriebswelle 30, beispielsweise mittels einer Welle-Nabe-Verbindung oder einem Pressverband, verdrehfest verbunden. Das erste Förderelement 11 und die Antriebswelle 30 sind zusammen um eine Drehachse D relativ zu dem Gehäuse 18 drehbar. Das erste Förderelement 11 bildet mit dem Gehäusedeckel 18a und dem Gehäusedeckel 18c jeweils einen Dichtspalt.

Das zweite Förderelement 12 ist als Innenzahnrad oder Hohlrad mit einer Innenverzahnung gebildet und wird von der Innenumfangsfläche des Gehäusegrundkörpers 18b drehbar gelagert. Das zweite Förderelement 12 ist um eine Drehachse drehbar, die parallel versetzt zu der Drehachse D angeordnet ist. Die Innenverzahnung des zweiten Förderelements 12 ist an einer Stelle des Umfangs in einem kämmenden Eingriff mit der Außenverzahnung des ersten Förderelements 11. Die Außenverzahnung des ersten Förderelements 11 weist weniger Zähne als die Innenverzahnung des zweiten Förderelements 12 auf. Der Außendurchmesser des ersten Förderelements 11 ist kleiner als der Innendurchmesser des zweiten Förderelements 12. Das Drehzahlverhältnis zwischen dem ersten Förderelement 11 und dem zweiten Förderelement 12 ist dergestalt, dass sich das erste Förderelement 11 mit einer größeren Drehzahl um die Drehachse D dreht als sich das zweite Förderelement 12 um seine, zu der Drehachse D parallel versetzte Drehachse dreht. Das zweite Förderelement 12 bildet mit dem ersten Gehäusedeckel 18a und dem zweiten Gehäusedeckel 18c jeweils einen Dichtspalt.

Das Pumpengehäuse 18, wie in diesem Beispiel gezeigt, der Gehäusedeckel 18a, bildet einen Einlass 13, insbesondere einen Einlasskanal, und einen Auslass 14, insbesondere einen Auslasskanal. Der Einlass 13 ist dazu ausgebildet, dass Fluid, insbesondere Öl, in die Pumpenkammer 15 strömen kann. Der Auslass 14 ist dazu ausgebildet, dass Fluid, insbesondere Öl, welches von dem ersten und zweiten Förderelement 11, 12 während des Betriebs der Pumpe gefördert wird, aus der Pumpenkammer 15 abströmt. Der Einlass 13 und der Auslass 14 sind jeweils als Kanal gebildet. Eine Einlassöffnung 13a des Einlasses 13 und eine Auslassöffnung 14a des Auslasses 14 weisen zu der Seite des Gehäusedeckels 18a, die zu einer Stirnwand 103 (Figur 3) eines Aufnahmeraums 104 weist. Der Pumpeneinsatz 1 ist zumindest teilweise in dem Aufnahmeraum 104, der die Stirnwand 103 und eine Umfangswand 102 bildet, angeordnet. Der insbesondere topfförmige Aufnahmeraum 104 wird von einem Aufnahmegehäuse 100 (Figur 3) gebildet.

Das Aufnahmegehäuse 100 weist einen Zuführkanal 65 auf, der mit einer Zuführkanalöffnung an die Stirnwand 103 mündet. Ferner weist das Aufnahmegehäuse 100 einen Abströmkanal auf, der mit einer Abströmkanalöffnung an die Stirnwand 103 mündet. Der Abströmkanal befindet sich in der Zeichenebene der Figur 3 hinter dem Zuführkanal 65 und ist daher nicht sichtbar, aber gleichwohl vorhanden. In dem gezeigten Beispiel weisen die Zuführkanalöffnung und die Einlassöffnung 13a zueinander und liegen einander gegenüber. Die Abströmkanalöffnung und die Auslassöffnung 14a weisen zueinander und liegen einander gegenüber.

Der Zuführkanal 65 ist mit dem Einlass 13 über ein rohrförmiges Verbindungselement 60, welches zwischen dem Zuführkanal 65 und dem Einlass 13 angeordnet ist, fluidkommunizierend verbunden. Der Abströmkanal ist mit dem Auslass 14 mittels eines rohrförmigen Verbindungselements 70, welches zwischen dem Abströmkanal und dem Auslass 14 angeordnet ist, fluidkommunizierend verbunden.

Wie beispielsweise aus der Figur 2 ersichtlich ist, ist das Verbindungselement 60 in den Einlass 13 eingesteckt und das Verbindungselement 70 in den Auslass 14 eingesteckt. Der Einlass 13 weist eine Innenumfangsfläche auf, und das Verbindungselement 60 weist eine Außenumfangsfläche auf, wobei ein Dichtring 61 zwischen der Innenumfangsfläche und der Außenumfangsfläche angeordnet ist und an diesen dichtend anliegt, um den dazwischen gebildeten Spalt abzudichten. Hierdurch ist der Einlass 13 in Bezug auf den Aufnahmeraum 104 abgedichtet.

Der Auslass 14 weist eine Innenumfangsfläche auf, und das Verbindungselement 70 weist eine Außenumfangsfläche auf, wobei ein Dichtring 71 zwischen der Innenumfangsfläche und der Außenumfangsfläche angeordnet ist und an diesen dichtend anliegt, um den dazwischen gebildeten Spalt abzudichten. Hierdurch ist der Auslass 14 in Bezug auf den Aufnahmeraum 104 abgedichtet. In dem Auslass 14 ist ein Rückschlagventil gebildet, welches einen Schließkörper 73, der in dem gezeigten Beispiel kugelförmig ist (Figur 1), aufweist und dazu ausgebildet ist, eine Fluidströmung von der Pumpenkammer 15 zu dem Abströmkanal zuzulassen, d. h. wenn der Schließkörper 73 von einem Ventilsitz abgehoben ist, und eine Strömung in die entgegengesetzte Richtung, d. h. wenn der Schließkörper 73 an dem Ventilsitz anliegt, von dem Abströmkanal in die Pumpenkammer 15 zu blockieren.

Wenn der Pumpeneinsatz 1 in den Aufnahmeraum 104 eingesetzt ist (Figur 3), sind das Verbindungselement 60 in den Zuführkanal 65 und das Verbindungselement 70 ist in den Abströmkanal eingesteckt. Die Verbindungselemente 60, 70 weisen jeweils eine Außenumfangsfläche auf und der Zuführkanal 65 und der Abströmkanal weisen jeweils eine Innenumfangsfläche auf. Der zwischen der Außenumfangsfläche und der Innenumfangsfläche gebildete Spalt ist jeweils durch einen Dichtring 62, 72 (Figur 1) abgedichtet, so dass der Zuführkanal 65 und der Abströmkanal in Bezug zueinander und in Bezug auf den Aufnahmeraum 104 abgedichtet sind.

Das Verbindungselement 60 und das Verbindungselement 70 weisen für den Dichtring 61, 62 bzw. 71, 72 jeweils einen ringnutförmigen Sitz auf, der die Außenumfangsfläche, an der der Dichtring anliegt, bildet.

Die Antriebswelle 30 ist mittels eines ersten Drehlagers 16 und eines zweiten Drehlagers 17 um die Drehachse D drehbar gelagert. Das erste Drehlager 16 und das zweite Drehlager 17 sind in dem gezeigten Ausführungsbeispiel jeweils als Gleitlager ausgeführt. Die Antriebswelle 30 stützt sich mittels des ersten Drehlagers 16 an dem Gehäusedeckel 18a und mittels des zweiten Drehlagers 17 an dem Gehäusedeckel 18c um die Drehachse D drehbar ab. Beispielsweise kann der Gehäusedeckel 18a, 18c selbst oder eine in dem Gehäusedeckel 18a, 18c angebrachte, insbesondere eingepresste, Gleitlagerbuchse (nicht gezeigt) das als Gleitlager ausgeführte Drehlager 16, 17 bilden.

Optional kann ein drittes Drehlager 9 (Figur 3) vorgesehen sein, welches beispielsweise so angeordnet ist, dass sich ein Rotor 21 des Elektromotors 20 zwischen dem ersten Drehlager 16 oder dem zweiten Drehlager 17 und dem dritten Drehlager 9 befindet bzw. dort angeordnet ist. Das dritte Drehlager 9 kann beispielsweise als Wälzlager oder Gleitlager ausgeführt sein. Die Antriebswelle 30 stützt sich insbesondere mit einem Ende über das dritte Drehlager 9 an einer Montagestruktur 25 drehbar ab. In Ausführungsformen ohne das Drehlager 9 kann der Rotor 21 fliegend gelagert sein, d. h. dass der Rotor 21 in einem Bereich der Antriebswelle 30 angebracht ist, der außerhalb des ersten und zweiten Lagers 16, 17 und nicht zwischen dem ersten und zweiten Lager 16, 17 angeordnet ist.

Die Montagestruktur 25 ist um die Drehachse D verdreh- und vorzugsweise auch axialfest mit dem Pumpengehäuse 18 verbunden, nämlich mittels mindestens einer, beispielsweise länglichen, Verbindungsstruktur 26 (Figuren 1 und 2). In den gezeigten Ausführungsformen ist die mindestens eine längliche Verbindungsstruktur 26 in der Gestalt mehrerer Schraubenbolzen ausgeführt. Die Verbindungsstruktur 26 erstreckt sich parallel zur Drehachse D. Die Montagestruktur 25 weist insbesondere im Bereich des Umfangs für jede Verbindungsstruktur 26 eine Bohrung, insbesondere Gewindebohrung, auf, in die ein Außengewinde der Verbindungsstruktur 26 eingeschraubt ist. Der Stator 22 des Elektromotors 20 an seinem Außenumfang für jede der Verbindungsstrukturen 26 einen Durchgang oder - wie beispielsweise in den Figuren 1 und 2 gezeigt - eine nutförmige, längliche Vertiefung auf, wobei sich die Verbindungsstruktur 26 in Nutlängsrichtung durch die nutförmige Vertiefung erstreckt. Hierdurch stützt sich der Stator 22 um die Drehachse D verdrehfest an der Verbindungsstruktur 26 ab. Das Pumpengehäuse 18, insbesondere die Gehäusedeckel 18a, 18c und der Gehäusegrundkörper 18b weisen für jeden der Verbindungsstrukturen 26 einen Durchgang auf, in denen eine der Verbindungsstrukturen 26 angeordnet ist. Zwischen einem Kopf der Verbindungsstruktur 26 oder einer auf die Verbindungsstruktur 26 aufgeschraubten Schraubenmutter und der Montagestruktur 25 sind der Gehäusedeckel 18a, der Gehäusegrundkörper 18b, der Gehäusedeckel 18c und der Stator 22 angeordnet bzw. eingeklemmt. In der in den Figuren gezeigten Ausführungsform liegt der Stator 22 mit einer ersten Stirnseite an dem Gehäusedeckel 18c und mit einer zweiten Stirnseite an der Montagestruktur 25 an.

Der Elektromotor 20 weist den mit dem Pumpengehäuse 18 und der Montagestruktur 25 um die Drehachse D verdreh- und axialfest verbundenen oder gekoppelten Stator 22 und den Rotor 21, welcher verdrehfest mit der Antriebswelle 30 verbunden, insbesondere in einem verdrehfesten Eingriff mit der Antriebswelle 30 ist, auf. In dem in den Figuren gezeigten Ausführungsbeispiel ist der Rotor 21 als Innenläufer ausgebildet. Der Rotor 21 wird von dem Stator 22 umgeben. Alternative Anordnungen von Rotor 21 und Stator 22 sind jedoch grundsätzlich möglich, so kann beispielsweise der Rotor 21 als Außenläufer ausgebildet sein, d. h. dass der Rotor 21 den Stator 22 zumindest teilweise umgibt.

Der Rotor 21 und das Förderelement 11 sind über die Antriebswelle 30 derart verbunden, insbesondere verdrehfest verbunden, dass eine Drehung des Rotors 21 eine Drehung des Förderelements 11 bewirkt.

Der Stator 22 weist über seinen Umfang mehrere Spulen 23 auf, welche beispielsweise gruppenweise (phasenweise) selektiv mit elektrischer Energie beaufschlagbar sind, wodurch Magnetfelder erzeugt werden, welche bewirken, dass der Rotor 21 relativ zu dem Stator 22 um die Drehachse D gedreht wird.

Der Stator 22 fasst einen Motorraum 52 des Elektromotors 20 ein, in dem der Rotor 21 angeordnet ist. Der Stator 22 bildet einen Teil des Außenumfangs oder die Außenseite des Pumpeneinsatzes 1. Mit anderen Worten begrenzt der Stator 22 den Aufnahmeraum 104, in dem der Pumpeneinsatz 1 zumindest teilweise, insbesondere zumindest die Pumpe 10 und der Elektromotor 20 angeordnet sind.

Wie aus der Figur 3 ersichtlich ist, ist der Gehäusedeckel 18a im Bereich des Drehlagers 16 zu dem Aufnahmeraum 104 hin offen, so dass eine direkte, fluidkommunizierende Verbindung zwischen dem Drehlager 16 und dem Aufnahmeraum 104 besteht. Die Drehlager 16, 17 sind nicht vollkommen flüssigkeitsdicht, so dass während des Förderbetriebs der Pumpe 10 sogenanntes Leckagefluid (Leckageflüssigkeit) aus dem Pumpenraum 15 über das Drehlager 16 und das Drehlager 17 fließen kann. Das durch das Drehlager 16 fließende Leckagefluid kann bei der in der Figur 3 gezeigten Ausführungsform direkt in den Aufnahmeraum 104 abgeführt werden. Das durch das Drehlager 17 fließende Leckagefluid wird zunächst in den Motorraum 52 geführt und von dort über einen Motorraumauslass 53 aus dem Motorraum 52 abgeführt. Der Motorraum 52 ist somit dazu vorgesehen, dass er von Fluid, insbesondere der Leckageflüssigkeit, wie z. B. Öl, durchflossen werden kann. Hierdurch können die in dem Motorraum 52 angeordneten Komponenten gekühlt und/oder geschmiert und alternativ oder zusätzlich die Montagestruktur 25 gekühlt werden. In der in den Figuren gezeigten Ausführungsform ist der Pumpeneinsatz 1 derart konfiguriert, dass das aus der Pumpenkammer 15 stammende Leckagefluid in den Motorraum 52 geleitet wird und insbesondere den Motorraum 52 durchfließt und über den Motorraumauslass 53 aus dem Motorraum 52 in den Aufnahmeraum 104 abgeführt wird.

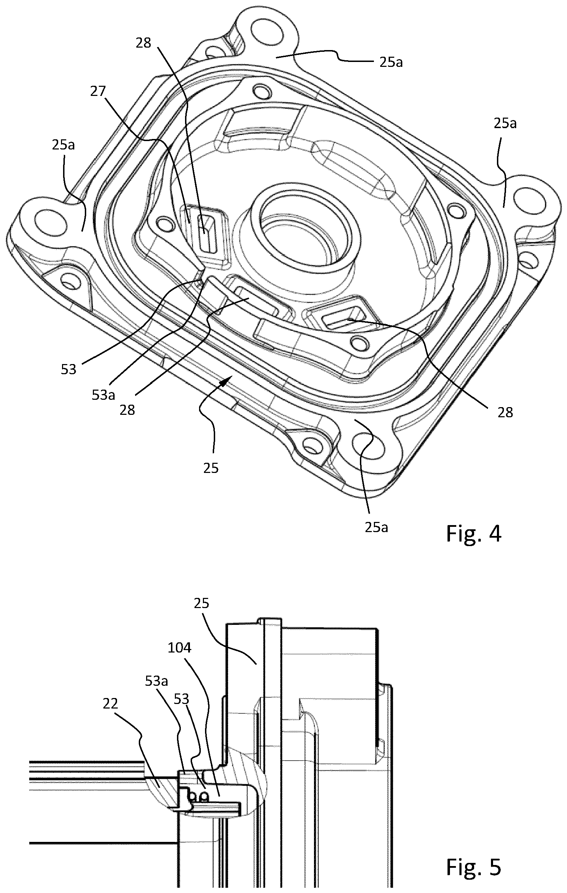

Wie in den Figuren 4 und 5 gezeigt, kann der Motorraumauslass 53 beispielsweise von der Haltestruktur 25 gebildet sein. Der Motorraumauslass 53 ist seitlich an dem Pumpeneinsatz 1 angeordnet (Figur 5). Eine Motorraumauslassöffnung 53a weist zu der Umfangswand 102 hin und mündet an den Außenumfang des Pumpeneinsatzes 1, insbesondere der Montagestruktur 25.

Die Pumpenanordnung kann so ausgebildet sein, dass das Fluid aus dem Aufnahmeraum 104 in einen Vorratsbehälter, wie zum Beispiel ein Flüssigkeits- oder Ölreservoir, welches beispielsweise ein Getriebesumpf sein kann, abführbar ist. Beispielsweise kann der Vorratsbehälter fluidkommunizierend mit dem Aufnahmeraum 104 verbunden sein. Hierzu kann das Aufnahmegehäuse 100 einen Abführkanal (nicht gezeigt) aufweisen, der in den Aufnahmeraum 104 mündet und zu dem Vorratsbehälter führt. Beispielsweise kann die Pumpe 10 die Flüssigkeit oder das Öl über den Einlass 13 und den Zuführkanal 65 aus dem Vorratsbehälter ansaugen.

Der Pumpeneinsatz 1 weist, wie z. B. aus der Figur 2 ersichtlich ist, eine Kontakteinheit 40 auf, die außerhalb des Aufnahmeraums 104 und an der Montagestruktur 25 angeordnet ist. Die Kontakteinheit 40 weist ein Elektronikgehäuse 41 auf, welches an der Montagestruktur 25 mittels mehrerer Schraubenbolzen 46 befestigt ist (Figur 1). Zwischen dem Elektronikgehäuse 41 und der Montagestruktur 25 ist eine als Dichtring ausgebildete Dichtung 8 angeordnet, welche einen Innenraum in Bezug auf die Umgebung des Pumpeneinsatzes 1 abdichtet.

Der Pumpeneinsatz 1 weist ein plattenförmiges Trägerelement 42, insbesondere eine Leiterplatte, auf, welche eine Steuerungselektronik 49 für die Steuerung des Elektromotors 20 aufweist. Die Steuerungselektronik 49 und/oder das Trägerelement 42 sind auf der dem Elektromotor 20 abgewandten Seite der Montagestruktur 25 angeordnet. Das Trägerelement 42 mit der Steuerungselektronik 49 ist in dem von dem Elektronikgehäuse 41 und der Montagestruktur 25 eingefassten Innenraum angeordnet.

Die Montagestruktur 25 ist in dem gezeigten Beispiel aus Metall oder einer Metalllegierung, wie z. B. einer Aluminiumlegierung, gebildet. Zwischen der Steuerungselektronik 49 oder einzelnen Komponenten davon, und der Montagestruktur 25 ist eine Wärmebrücke gebildet, über die ein Wärmetransport von der Steuerungselektronik 49 zu der Montagestruktur 25 ermöglicht wird. Die Wärmebrücke kann dadurch bewirkt werden, dass das Trägerelement 42 oder/und einzelne elektronische Komponenten, die im Betrieb einer Kühlung bedürfen, an einer Oberfläche des aus Metall oder einer Metalllegierung gebildeten Montagestruktur 25 anliegen. Dadurch kann Wärmeenergie von der Steuerungselektronik 49 oder Komponenten davon, in die Montagestruktur 25 abgeführt werden.

Wie aus den Figuren 1 und 3 ersichtlich ist, kann zwischen der Steuerungselektronik 49 oder einzelnen Komponenten davon, oder dem Trägerelement 42 und der Montagestruktur 25 mindestens ein Wärmeleitelement 44 angeordnet sein, um den Wärmetransport von der Steuerungselektronik 49 oder Komponenten davon in die Montagestruktur 25 zu verbessern. Das mindestens eine Wärmeleitelement 44 kann beispielsweise Wärmeleitpaste oder ein Wärmeleitpad sein. Beispielsweise können mehrere zu kühlende Komponenten der Steuerungselektronik 49 mittels eines gemeinsamen Wärmeleitelements 44 zur Bildung der Wärmebrücke mit der Montagestruktur 25 verbunden sein. Alternativ oder zusätzlich können mehrere Wärmeleitelemente 44 vorgesehen sein, wobei für mehrere Komponenten jeweils ein einer einzelnen Komponente zugeordnetes Wärmeleitelement 44 vorgesehen sein kann (siehe Figur 1).

Wie es beispielsweise aus den Figuren 1 und 3 ersichtlich ist, weist das Elektronikgehäuse 41 ein oder mehrere Niederhalteelemente 45 auf, welche von seiner inneren Stirnwand abstehen und das Trägerelement 42 zu der oder an die Montagestruktur 25 drücken. Dadurch kann der Wärmeübergang zwischen der Steuerungselektronik 49 und der Montagestruktur 25 erhöht oder verbessert werden.

Zwischen der Montagestruktur 25 und dem Aufnahmegehäuse 100 ist eine Wärmebrücke gebildet, über die ein Wärmetransport von der Montagestruktur 25 in das Aufnahmegehäuse 100 bewirkt werden kann. Die Montagestruktur 25 weist einen Flansch auf, mit dem die Montagestruktur 25 und somit der Pumpeneinsatz 1 an dem Aufnahmegehäuse 100 befestigt ist. Das Aufnahmegehäuse 100 weist eine, insbesondere stirnseitige, Montagefläche 101 auf, der eine von dem Flansch gebildete Stirnfläche der Montagestruktur 25 gegenüberliegt. Der Flansch kann mittels eines oder mehrerer Befestigungselemente, beispielsweise Schraubenbolzen, an dem Aufnahmegehäuse 100 befestigt sein, die den Flansch zu dem Aufnahmegehäuse 100 hin spannen. Die Montagestruktur 25, insbesondere deren Flansch, kann unmittelbar an dem Aufnahmegehäuse 100 anliegen. Alternativ kann zwischen der Montagestruktur 25, insbesondere deren Flansch, und dem Aufnahmegehäuse 100 ein Wärmeleitelement 105 angeordnet sein. Bei dem Wärmeleitelement 105 kann es sich insbesondere um Wärmeleitpaste oder ein Wärmeleitpad handeln. Hierdurch wird die Wärmeübertragung zwischen der Montagestruktur 25 und dem Aufnahmegehäuse 100 verbessert oder erhöht.

Die zwischen der Montagestruktur 25 des Pumpeneinsatzes 1 und dem Aufnahmegehäuse 100 gebildete Wärmebrücke, die Montagestruktur 25 und die zwischen der für die Steuerung des Motors 20 ausgebildeten Steuerungselektronik 49 und der Montagestruktur 25 gebildeten Wärmebrücke sind so aufeinander abgestimmt, dass die während des Betriebs des Elektromotors 20 in der Steuerungselektronik 49 entstehende Wärme zumindest größtenteils über die zwischen der Steuerungselektronik 49 und der Montagestruktur 25 gebildete Wärmebrücke, die Montagestruktur 25 und die zwischen der Montagestruktur 25 und dem Aufnahmegehäuse 100 gebildete Wärmebrücke in das Aufnahmegehäuse 100 abgeführt wird.

Die Montagestruktur 25 bildet einen Deckel, der den Aufnahmeraum 104 abschließt. Zwischen der Montagestruktur 25 und dem Aufnahmegehäuse 100, insbesondere zwischen dem Flansch, welcher der Montagefläche 101 des Aufnahmegehäuses 100 gegenüberliegt, und der Montagefläche 101 ist eine ringförmige Dichtung 7 angeordnet, welche den Aufnahmeraum 104 nach außen hin abdichtet. Die Montagestruktur 25 weist eine nutförmige, insbesondere ringnutförmige Vertiefung auf, in welcher die ringförmige Dichtung 7 angeordnet ist. Die ringförmige Dichtung 7 liegt in der ringförmigen Nut einerseits und an der Montagefläche 101 andererseits dichtend an, um den Aufnahmeraum 104 in Bezug auf die Umgebung abzudichten.

Die Kontakteinheit 40 oder die Steuerungselektronik 49 ist mit den Spulen 23 des Stators 22 elektrisch leitend verbunden, d. h. kontaktiert. Wie beispielsweise aus der Figur 3 ersichtlich ist, ist die Montagstruktur 25 zwischen der Kontakteinheit 40 und dem Rotor 21 und/oder dem Stator 22 angeordnet. Die Montagestruktur 25 weist mehrere Durchgänge 28 für jeweils ein Kontaktelement 47, insbesondere eine Kontaktzunge, auf. Der Durchgang 28 wird von einem Dichtelement 27, welches beispielsweise eine Gummidichtung oder eine nachträglich eingebrachte Dicht- oder Vergussmasse sein kann, gebildet. In dem in der Figur 3 gezeigten Beispiel ragt jedes der am Stator 22 gebildeten Kontaktelemente 47 von dem Stator 22 zu der Kontakteinheit 40 hin ab und erstreckt sich jeweils durch einen der Durchgänge 28. Die Kontakteinheit 40, insbesondere die Steuerungselektronik 49, weist mehrere Kontaktgegenelemente 24 auf, die jeweils mit einer Spule 23 oder einer Gruppe von Spulen 23 elektrisch leitend verbunden, d. h. kontaktiert sind. Jedes der sich durch den Durchgang 28 hindurch erstreckenden Kontaktelemente 47 ist einem der Kontaktgegenelemente 24 zugeordnet, mit dem er eine Steckverbindung zur elektrischen Kontaktierung mit der Steuerungselektronik 49 oder allgemein der Kontakteinheit 40 bildet. Das Zusammenstecken der Kontaktelemente 47 und der Kontaktgegenelemente 24 kann beispielsweise dadurch erfolgen, dass die Montagestruktur 25 zusammen mit der Kontakteinheit 40 an dem Stator 22 angebracht wird, beispielsweise durch Anstecken in axialer Richtung entlang der Drehachse D. Die Kontaktelemente 47 erstrecken sich durch die Montagestruktur 25 hindurch, nämlich durch die Durchgänge 28, wobei die Kontaktgegenelemente 24 auf der dem Elektromotor 20 abgewandten Seite der Montagestruktur 25, beispielsweise in dem von dem Elektronikgehäuse 41 und der Montagestruktur 25 eingefassten Innenraum angeordnet sind.

Alternativ kann das Kontaktelement 47 an dem Trägerelement 42 gebildet sein und von dem Trägerelement 42 durch den Durchgang 28 hindurch ragen. Die Kontaktgegenelemente 24 können an dem Stator 22 gebildet sein und das Kontaktelement 47 auf der Seite der Montagestruktur 25, welche dem Stator 22 zugewandt ist, elektrisch kontaktieren.

Die Kontakteinheit 40 weist mindestens einen elektrischen Steckverbinder 43 auf. Der mindestens eine elektrische Steckverbinder 43 kann zumindest zum Teil von dem Elektronikgehäuse 41 gebildet sein und/oder dient zur Versorgung der Steuerungselektronik 49 und/oder der Spulen 23 mit elektrischer Energie. Der elektrische Steckverbinder 43 ist außerhalb des Aufnahmeraums 104 angeordnet.

### Bezugszeichenliste

| | | | |
|---|---|---|---|
| 1 | Pumpeneinsatz | 60 | Verbindungselement |
| 7 | Dichtung / Dichtring | 61 | Dichtring |
| 8 | Dichtung / Dichtring | 62 | Dichtring |
| 9 | drittes Drehlager | 65 | Zuführkanal |
| | | 70 | Verbindungselement |
| 10 | Pumpe | 71 | Dichtring |
| 11 | erstes Förderelement / Zahnrad | 72 | Dichtring |
| 12 | zweites Förderelement / Innenzahnrad | 73 | Schließkörper |
| 13 | Einlass | 100 | Aufnahmegehäuse |
| 13a | Einlassöffnung | 101 | Montagefläche |
| 14 | Auslass | 102 | Umfangswand |
| 14a | Auslassöffnung | 103 | StirnwandBoden |
| 15 | Pumpenkammer | 104 | Aufnahmeraum |
| 16 | erstes Drehlager / Gleitlager | 105 | Wärmeleitelement |
| 17 | zweites Drehlager / Gleitlager | | |
| 18 | Pumpengehäuse | D | Drehachs |
| 18a | erster Gehäusedeckel | | |
| 18b | Gehäusegrundkörper | | |
| 18c | zweiter Gehäusedeckel | | |
| 19 | Passstift | | |
| 20 | Elektromotor | | |
| 21 | Rotor | | |
| 22 | Stator | | |
| 23 | Spule | | |
| 24 | Kontaktgegenelement | | |
| 25 | Montagestruktur | | |
| 25a | Kontaktfläche | | |
| 26 | Verbindungsstruktur | | |
| 27 | Dichtelement | | |
| 28 | Durchgang | | |
| 30 | Antriebswelle | | |
| 40 | Kontakteinheit | | |
| 41 | Elektronikgehäuse | | |
| 42 | Trägerelement | | |
| 43 | elektrischer Steckverbinder | | |
| 44 | Wärmeleitelement | | |
| 45 | Niederhalteelement | | |
| 46 | Schraubenbolzen | | |
| 47 | Kontaktelement / Kontaktzunge | | |
| 49 | Steuerungselektronik | | |
| 52 | Motorraum | | |
| 53 | Motorraumauslass | | |
| 53a | Motorraumauslassöffnung | | |

## Patentansprüche

1. Pumpenanordnung, umfassend ein Aufnahmegehäuse (100), welches einen, insbesondere topfförmigen, Aufnahmeraum (104) mit einer Stirnwand (103) und einer Umfangswand (102) bildet und einen Pumpeneinsatz (1) zur zumindest teilweisen Anordnung in dem Aufnahmeraum (104), wobei der Pumpeneinsatz (1) aufweist:
- eine Pumpe (10) mit einer Pumpenkammer (15) und einem um eine Drehachse (D) drehbaren Förderelement (11), welches in der Pumpenkammer (15) angeordnet ist,
- einen Elektromotor (20) mit einem um die Drehachse (D) drehbaren Rotor (21) und einem Stator (22), und
- eine um die Drehachse (D) drehbar gelagerte Antriebswelle (30), wobei der Rotor (21) und das Förderelement (11) über die Antriebswelle (30) derart verbunden sind, dass eine Drehung des Rotors (21) eine Drehung des Förderelements (11) bewirkt,
wobei der Pumpeneinsatz (1) auf der zu der Stirnwand (103) des Aufnahmeraums (104) weisenden Seite einen Einlass (13), der ausgebildet ist, der Pumpenkammer (15) Fluid zuzuführen, und einen Auslass (14), der angepasst ist, aus der Pumpenkammer (15) Fluid abzuführen, aufweist, und
wobei das Aufnahmegehäuse (100) an seiner Stirnwand (103) einen Zuführkanal (65) und einen Abströmkanal aufweist,
**gekennzeichnet durch**
ein in den Einlass (13) eingestecktes, rohrförmiges Verbindungselement (60), welches zwischen dem Zuführkanal (65) und dem Einlass (13) angeordnet ist und diese fluidkommunizierend verbindet, und ein in den Auslass (14) eingestecktes, rohrförmiges Verbindungselement (70), welches zwischen dem Abströmkanal und dem Auslass (14) angeordnet ist und diese fluidkommunizierend verbindet.

2. Pumpenanordnung nach Anspruch 1, wobei der Pumpeneinsatz (1) eine Montagestruktur (25), insbesondere aus Metall oder einer Metalllegierung, aufweist, mit welcher der Pumpeneinsatz (1) an einem Aufnahmegehäuse (100), insbesondere aus Metall oder einer Metalllegierung, befestigbar ist, wobei bevorzugt ist, dass der Pumpeneinsatz (1) eine Steuerungselektronik (49) für die Steuerung des Elektromotors (20) aufweist, wobei zwischen der Steuerungselektronik (49) und der Montagestruktur (25) eine Wärmebrücke gebildet ist, über die ein Wärmetransport von der Steuerungselektronik (49) zu der Montagestruktur (25) bewirkbar ist.

3. Pumpenanordnung nach dem vorhergehenden Anspruch, **dadurch gekennzeichnet, dass** zwischen der Steuerungselektronik (49) und der Montagestruktur (25) ein Wärmeleitelement (44), insbesondere Wärmeleitpaste oder ein Wärmleitpad, angeordnet ist, und/oder dass die Steuerungselektronik (49) zumindest teilweise auf einem Trägerelement (42), insbesondere einer Leiterplatte, angeordnet ist, wobei in dem Bereich einer oder mehrerer Komponenten der Steuerungselektronik (49) ein oder jeweils ein Wärmeleitelement (44) zwischen der Komponente und der Montagestruktur (25) angeordnet ist und/oder ein oder mehrere Wärmeleitelemente (44) zwischen dem Trägerelement (42) und der Montagestruktur (25) angeordnet sind.

4. Pumpenanordnung nach Anspruch 2 oder 3, **gekennzeichnet durch** ein Elektronikgehäuse (41), beispielsweise aus Kunststoff, welches an der Montagestruktur (25) befestigt ist und in dem eine Steuerungselektronik (49) für den Elektromotor (20) angeordnet ist, wobei das Elektronikgehäuse (41) ein oder mehrere Niederhalteelemente (45) aufweist, welche ein Trägerelement (42), insbesondere eine Leiterplatte, auf dem die Steuerungselektronik (49) zumindest teilweise angeordnet ist, zu der oder an die Montagestruktur (25) drücken.

5. Pumpenanordnung nach einem der Ansprüche 2 bis 4, **dadurch gekennzeichnet, dass** die Montagestruktur (25) mindestens einen Durchgang (28) aufweist, durch welchen sich mindestens ein Kontaktelement (47) erstreckt, welches die Elektronikeinheit (49) und mindestens eine Spule (23) des Stators (22) elektrisch kontaktiert.

6. Pumpenanordnung nach einem der Ansprüche 2 bis 5, **dadurch gekennzeichnet, dass** sich die Antriebswelle (30) um die Drehachse (D) drehbar an dem Montagegehäuse (25) abstützt, und/oder dass der Pumpeneinsatz (1), insbesondere eine Montagestruktur (25), einen Motorraumauslass (53) aufweist, welcher einen von dem Stator (22) umfangsseitig umgebenen Motorraum (53) mit der Außenseite des Pumpeneinsatzes (1) fluidkommunizierend verbindet und/oder an die Außenseite mündet.

7. Pumpenanordnung nach einem der vorhergehenden Ansprüche, wobei der Pumpeneinsatz (1) eine Montagestruktur (25), insbesondere aus Metall oder einer Metalllegierung, aufweist, mit welcher der Pumpeneinsatz (1) an dem Aufnahmegehäuse (100), insbesondere aus Metall oder einer Metalllegierung, befestigt ist, wobei bevorzugt ist, dass zwischen der Montagestruktur (25) und dem Aufnahmegehäuse (100) eine Wärmebrücke gebildet ist, über die ein Wärmetransport von der Montagestruktur (25) zu dem Aufnahmegehäuse (100) bewirkbar ist und/oder dass die Montagestruktur (25) an dem Aufnahmegehäuse (100) anliegt.

8. Pumpenanordnung nach Anspruch 7, **dadurch gekennzeichnet, dass** zwischen der Montagestruktur (25) und dem Aufnahmegehäuse (100) ein Wärmeleitelement (105), insbesondere Wärmeleitpaste oder ein Wärmleitpad, angeordnet ist.

9. Pumpenanordnung nach einem der vorhergehenden Ansprüche, **dadurch gekennzeichnet, dass** eine zwischen einer Montagestruktur (25) des Pumpeneinsatzes (1) und dem Aufnahmegehäuse (100) gebildete Wärmebrücke, die Montagestruktur (25) und eine zwischen einer für die Steuerung des Elektromotors (20) ausgebildete Steuerungselektronik (49) und der Montagestruktur (25) gebildete Wärmebrücke so aufeinander abgestimmt sind, dass die während des Betriebs des Elektromotors (20) in der Steuerungselektronik (49) entstehende Wärme zumindest größtenteils über die zwischen der Steuerungselektronik (49) und der Montagestruktur (25) gebildete Wärmebrücke, die Montagestruktur (25) und die zwischen der Montagestruktur (25) und dem Aufnahmegehäuse (100) gebildete Wärmebrücke in das Aufnahmegehäuse (100) abgeführt wird oder abführbar ist.

10. Pumpenanordnung nach einem der Ansprüche 7 bis 9, **dadurch gekennzeichnet, dass** die Montagestruktur (25) einen Deckel bildet, der den Aufnahmeraum (104) abschließt und/oder zwischen der Montagestruktur (25) und dem Aufnahmegehäuse (100) eine, insbesondere ringförmige, Dichtung (7) angeordnet ist, welche den Aufnahmeraum (104) nach außen hin abdichtet.

11. Pumpenanordnung nach einem der Ansprüche 7 bis 10, **dadurch gekennzeichnet, dass** die Montagestruktur (25) an dem Aufnahmegehäuse (100) angeflanscht ist, wobei bevorzugt ist, dass die Montagestruktur (25) mittels mindestens eines Schraubenbolzens an dem Aufnahmegehäuse (100) befestigt ist.

12. Pumpenanordnung nach einem der Ansprüche 7 bis 11, **dadurch gekennzeichnet, dass** der Pumpeneinsatz (1), insbesondere die Montagestruktur (25), einen Motorraumauslass (53) aufweist, welcher einen von dem Stator (22) umfangsseitig umgebenen Motorraum (53) mit dem Aufnahmeraum (104) fluidkommunizierend verbindet, wobei bevorzugt ist, dass der Motorraumauslass (53) seitlich an dem Pumpeneinsatz (1) angeordnet ist oder der Motorraumauslass (53) mit einer Motorraumauslassöffnung (53a) zu der Umfangswand (102) hin gewandt an die Außenseite des Pumpeneinsatzes (1), insbesondere der Montagestruktur (25), mündet.

13. Pumpenanordnung nach einem der vorhergehenden Ansprüche, **dadurch gekennzeichnet, dass** das Aufnahmegehäuse (100) einen Abführkanal aufweist, der in den Aufnahmeraum (104) mündet und über den Fluid aus dem Aufnahmeraum (104), insbesondere zu einem Vorratsbehälter hin, abführbar ist.

14. Pumpenanordnung nach einem der vorhergehenden Ansprüche, **dadurch gekennzeichnet, dass** der Aufnahmeraum (104) in Bezug auf den Einlass (13) und den Auslass (14) abgedichtet ist.

15. Pumpenanordnung nach einem der vorhergehenden Ansprüche, **dadurch gekennzeichnet, dass** ein Dichtelement (61, 71) vorgesehen ist, welches einen Dichtspalt zwischen dem rohrförmigen Verbindungselement (60, 70) und dem Einlass (13) bzw. Auslass (14) abdichtet.

16. Pumpenanordnung nach einem der vorhergehenden Ansprüche, **dadurch gekennzeichnet, dass** der Stator (22) zumindest einen Teil des Außenumfangs oder der Außenseite des Pumpeneinsatzes (1) bildet und/oder den Aufnahmeraum (104) begrenzt.

## Claims

1. A pump array, comprising: an accommodating housing (100) which forms an accommodating space (104), in particular a cup-shaped accommodating space (104) comprising an end-facing wall (103) and a circumferential wall (102); and a pump insert (1) for arranging at least partially in the accommodating space (104), the pump insert (1) comprising:
- a pump (10) comprising a pump chamber (15) and a delivery element (11) which can rotate about a rotational axis (D) and which is arranged in the pump chamber (15);
- an electric motor (20) comprising a rotor (21), which can rotate about the rotational axis (D), and a stator (22); and
- a drive shaft (30) which is mounted such that it can rotate about the rotational axis (D), wherein the rotor (21) and the delivery element (11) are connected via the drive shaft (30) in such a way that rotating the rotor (21) causes the delivery element (11) to rotate,
wherein the pump insert (1) comprises an inlet (13), which is embodied to feed fluid to the pump chamber (15), and/or an outlet (14), which is adapted to discharge fluid from the pump chamber (15), on the side pointing towards the end-facing wall (103) of the accommodating space (104), and
wherein the end-facing wall (103) of the accommodating housing (100) comprises a feed channel (65) and a drainage channel,
**characterised by**
a tubular connecting element (60) which is inserted into the inlet (13) and arranged between the feed channel (65) and the inlet (13) and which connects them in fluid communication, and a tubular connecting element (70) which is inserted into the outlet (14) and arranged between the drainage channel and the outlet (14) and which connects them in fluid communication.

2. The pump array according to claim 1, wherein the pump insert (1) comprises an assembly structure (25), made in particular of metal or a metal alloy, using which the pump insert (1) can be fastened to the accommodating housing (100), made in particular of metal or a metal alloy, wherein the pump insert (1) preferably comprises control electronics (49) for controlling the electric motor (20), wherein a thermal bridge is formed between the control electronics (49) and the assembly structure (25), via which heat can be transmitted from the control electronics (49) to the assembly structure (25).

3. The pump array according to the preceding claim, **characterised in that** a thermally conductive element (44), in particular thermally conductive paste or a thermally conductive pad, is arranged between the control electronics (49) and the assembly structure (25), and/or **in that** the control electronics (49) are arranged at least partially on a carrier (42), in particular a printed circuit board, wherein in the region of (each of) one or more components of the control electronics (49), a thermally conductive element (44) is arranged between the component and the assembly structure (25) and/or one or more thermally conductive elements (44) are arranged between the carrier (42) and the assembly structure (25).

4. The pump array according to claim 2 or 3, **characterised by** an electronics housing (41), made for example of plastic, which is fastened to the assembly structure (25) and in which control electronics (49) for the electric motor (20) are arranged, wherein the electronics housing (41) comprises one or more hold-down elements (45) which press a carrier (42), in particular a printed circuit board, on which the control electronics (49) are at least partially arranged, against or onto the assembly structure (25).

5. The pump array according to any one of claims 2 to 4, **characterised in that** the assembly structure (25) comprises at least one passage (28) through which at least one contact element (47) extends which electrically contacts an electronics unit and at least one coil (23) of the stator (22).

6. The pump array according to any one of claims 2 to 5, **characterised in that** the drive shaft (30) is supported on the assembly structure (25) such that it can rotate about the rotational axis (D), and/or **in that** the pump insert (1), in particular the assembly structure (25), comprises a motor space outlet (53) which connects a motor space (52), which is surrounded by the stator (22) on the circumferential side, in fluid communication with the outer side of the pump insert (1) and/or emerges onto the outer side.

7. The pump array according to any one of the preceding claims, wherein the pump insert (1) comprises the assembly structure (25), made in particular of metal or a metal alloy, using which the pump insert (1) is fastened to the accommodating housing (100), made in particular of metal or a metal alloy, wherein a thermal bridge is preferably formed between the assembly structure (25) and the accommodating housing (100), via which heat can be transmitted from the assembly structure (25) to the accommodating housing (100), and/or in that the assembly structure (25) abuts the accommodating housing (100).

8. The pump array according to claim 7, **characterised in that** a thermally conductive element (105), in particular thermally conductive paste or a thermally conductive pad, is arranged between the assembly structure (25) and the accommodating housing (100).

9. The pump array according to any one of the preceding claims, **characterised in that** a thermal bridge formed between the assembly structure (25) of the pump insert (1) and the accommodating housing (100), the assembly structure (25) itself and a thermal bridge formed between the assembly structure (25) and the control electronics (49) embodied to control the electric motor (20) are adjusted to each other such that the heat generated in the control electronics (49) while the electric motor (20) is in operation is or can be at least mostly discharged into the accommodating housing (100) via the thermal bridge formed between the control electronics (49) and the assembly structure (25), the assembly structure (25) itself and the thermal bridge formed between the assembly structure (25) and the accommodating housing (100).

10. The pump array according to any one of claims 7 to 9, **characterised in that** the assembly structure (25) forms a cover which closes off the accommodating space (104), and/or a gasket which is in particular an annular gasket (7) and seals off the accommodating space (104) from the outside is arranged between the assembly structure (25) and the accommodating housing (100).

11. The pump array according to any one of claims 7 to 10, **characterised in that** the assembly structure (25) is flange-mounted to the accommodating housing (100), wherein the assembly structure (25) is preferably fastened to the accommodating housing (100) by means of at least one stud-bolt.

12. The pump array according to any one of claims 7 to 11, **characterised in that** the pump insert (1), in particular the assembly structure (25), comprises a motor space outlet (53) which connects a motor space (52), which is surrounded by the stator (22) on the circumferential side, in fluid communication with the accommodating space (104), wherein the motor space outlet (53) is preferably arranged laterally on the pump insert (1), or the motor space outlet (53) emerges onto the outer side of the pump insert (1), in particular the assembly structure (25), via a motor space outlet opening (53a) pointed towards the circumferential wall (102).

13. The pump array according to any one of the preceding claims, **characterised in that** the accommodating housing (100) comprises a discharge channel which emerges into the accommodating space (104) and via which fluid can be discharged from the accommodating space (104), in particular towards a storage container.

14. The pump array according to any one of the preceding claims, **characterised in that** the accommodating space (104) is sealed off in relation to the inlet (13) and the outlet (14).

15. The pump array according to any one of the preceding claims, **characterised in that** a sealing element (61, 71) is provided which seals off a gap between the tubular connecting element (60, 70) and the inlet (13) and/or outlet (14).

16. The pump array according to any one of the preceding claims, **characterised in that** the stator (22) forms at least a part of the outer circumference or the outer side of the pump insert (1) and/or delineates the accommodating space (104).

## Revendications

1. Ensemble de pompe comprenant un boîtier de réception (100) formant un espace de réception (104), en particulier un espace de réception (104) en forme de pot présentant une paroi frontale (103) et une paroi circonférentielle (102), ainsi qu'un insert de pompe (1) pour disposer au moins partiellement dans l'espace de réception (104), l'insert de pompe (1) présentant :
- une pompe (10) présentant une chambre de pompe (15) et un élément de refoulement (11) pouvant tourner autour d'un axe de rotation (D) et disposé dans la chambre de pompe (15) ;
- un moteur électrique (20) présentant un rotor (21) pouvant tourner autour de l'axe de rotation (D) et un stator (22) ; et
- un arbre d'entraînement (30) monté de manière rotative autour de l'axe de rotation (D), le rotor (21) et l'élément de refoulement (11) étant reliés par l'intermédiaire de l'arbre d'entraînement (30) de telle sorte qu'une rotation du rotor (21) provoque une rotation de l'élément de refoulement (11),
l'insert de pompe (1) présentant, sur le côté dirigé vers la paroi frontale (103) de l'espace de réception (104), une entrée (13) réaliseée pour alimenter du fluide à la chambre de pompe (15) et / ou une sortie (14) adaptée pour évacuer du fluide depuis la chambre de pompe (15), et
le boîtier de réception (100) présentant un canal d'alimentation (65) et un canal d'écoulement sur sa paroi frontale (103),
**caractérisé par**
un élément de liaison tubulaire (60) inséré dans l'entrée (13) et disposé entre le canal d'alimentation (65) et l'entrée (13) et les reliant en communication fluidique, et un élément de liaison tubulaire (70) inséré dans la sortie (14) et disposé entre le canal d'écoulement et la sortie (14) et les reliant en communication fluidique.

2. Ensemble de pompe selon la revendication 1, dans lequel l'insert de pompe (1) présente une structure de montage (25), en particulier en métal ou en alliage métallique, par laquelle l'insert de pompe (1) peut être fixé à un boîtier de réception (100), en particulier en métal ou en alliage métallique, l'insert de pompe (1) présentant de préférence une électronique de commande (49) pour commander le moteur électrique (20), un pont thermique étant formé entre l'électronique de commande (49) et la structure de montage (25), par l'intermédiaire duquel la chaleur peut être transportée depuis l'électronique de commande (49) vers la structure de montage (25).

3. Ensemble de pompe selon la revendication précédente, **caractérisé en ce qu'**un élément thermoconducteur (44), en particulier de la pâte thermoconductrice ou un tampon thermoconducteur, est disposé entre l'électronique de commande (49) et la structure de montage (25) et / ou **en ce que** l'électronique de commande (49) est disposée au moins partiellement sur un élément de support (42), en particulier une carte imprimée, un ou chaque élément thermoconducteur (44) dans la zone d'un ou de plusieurs composants de l'électronique de commande (49) étant disposé entre ledit composant et la structure de montage (25) et / ou un ou plusieurs éléments thermoconducteurs (44) étant disposés entre l'élément de support (42) et la structure de montage (25).

4. Ensemble de pompe selon la revendication 2 ou 3, **caractérisé par** un boîtier électronique (41), par exemple en matière plastique, fixé à la structure de montage (25) et dans lequel est disposée une électronique de commande (49) pour le moteur électrique (20), le boîtier électronique (41) présentant un ou plusieurs éléments de retenue (45) pressant un élément de support (42), en particulier une carte imprimée, sur lequel l'électronique de commande (49) est disposée au moins partiellement, vers ou contre la structure de montage (25).

5. Ensemble de pompe selon l'une quelconque des revendications 2 à 4, **caractérisé en ce que** la structure de montage (25) présente au moins un passage (28) à travers lequel s'étend au moins un élément de contact (47) étant en contact électrique avec une unité électronique et avec au moins une bobine (23) du stator (22).

6. Ensemble de pompe selon l'une quelconque des revendications 2 à 5, **caractérisé en ce que** l'arbre d'entraînement (30) s'appuie de manière rotative autour de l'axe de rotation (D) sur la structure de montage (25) et / ou **en ce que** l'insert de pompe (1), en particulier la structure de montage (25), présente une sortie d'espace de moteur (53) reliant un espace de moteur (52) entouré sur la circonférence par le stator (22) à la face externe de l'insert de pompe (1) en communication fluidique et / ou débouchant sur la face externe.

7. Ensemble de pompe selon l'une quelconque des revendications précédentes, dans lequel l'insert de pompe (1) présente la structure de montage (25), en particulier en métal ou en alliage métallique, par laquelle l'insert de pompe (1) est fixé au boîtier de réception (100), en particulier en métal ou en alliage métallique, un pont thermique étant de préférence formé entre la structure de montage (25) et le boîtier de réception (100), par l'intermédiaire duquel la chaleur peut être transportée depuis la structure de montage (25) vers le boîtier de réception (100) et / ou la structure de montage (25) reposant de préférence sur le boîtier de réception (100).

8. Ensemble de pompe selon la revendication 7, **caractérisé en ce qu'**un élément thermoconducteur (105), en particulier de la pâte thermoconductrice ou un tampon thermoconducteur, est disposé entre la structure de montage (25) et le boîtier de réception (100).

9. Ensemble de pompe selon l'une quelconque des revendications précédentes, **caractérisé en ce qu'**un pont thermique formé entre la structure de montage (25) de l'insert de pompe (1) et le boîtier de réception (100), la structure de montage (25) et un pont thermique formé entre la structure de montage (25) et l'électronique de commande (49) réalisée pour commander le moteur électrique (20) sont concordés l'un avec l'autre de sorte que la chaleur générée dans l'électronique de commande (49) lorsque le moteur électrique (20) est en fonctionnement est évacuée ou peut être évacuée au moins pour la plupart dans le boîtier de réception (100) par l'intermédiaire du pont thermique formé entre l'électronique de commande (49) et la structure de montage (25), de la structure de montage (25) et du pont thermique formé entre la structure de montage (25) et le boîtier de réception (100).

10. Ensemble de pompe selon l'une quelconque des revendications 7 à 9, **caractérisé en ce que** la structure de montage (25) forme un couvercle fermant l'espace de réception (104) et / ou **en ce qu'**un joint d'étanchéité (7), en particulier un joint d'étanchéité annulaire (7), disposé entre la structure de montage (25) et le boîtier de réception (100) étanche l'espace de réception (104) vers l'extérieur.

11. Ensemble de pompe selon l'une quelconque des revendications 7 à 10, **caractérisé en ce que** la structure de montage (25) est bridée sur le boîtier de réception (100), la structure de montage (25) étant de préférence fixée au boîtier de réception (100) au moyen d'au moins un boulon fileté.

12. Ensemble de pompe selon l'une quelconque des revendications 7 à 11, **caractérisé en ce que** l'insert de pompe (1), en particulier la structure de montage (25), présente une sortie d'espace de moteur (53) reliant un espace de moteur (52) entouré sur la circonférence par le stator (22) à l'espace de réception (104) en communication fluidique, la sortie d'espace de moteur (53) étant de préférence disposée latéralement sur l'insert de pompe (1), ou une ouverture de sortie d'espace de moteur (53a) de la sortie d'espace de moteur (53) débouchant de préférence sur la face externe de l'insert de pompe (1), en particulier la face externe de la structure de montage (25), de manière tournée vers la paroi circonférentielle (102).

13. Ensemble de pompe selon l'une quelconque des revendications précédentes, **caractérisé en ce que** le boîtier de réception (100) présente un canal d'évacuation débouchant dans l'espace de réception (104) et par l'intermédiaire duquel du fluide peut être évacué depuis l'espace de réception (104), en particulier vers un conteneur de stockage.

14. Ensemble de pompe selon l'une quelconque des revendications précédentes, **caractérisé en ce que** l'espace de réception (104) est étanché par rapport à l'entrée (13) et à la sortie (14).

15. Ensemble de pompe selon l'une quelconque des revendications précédentes, **caractérisé en ce qu'**un élément d'étanchéité (61, 71) prévu étanche une fente d'étanchéité entre l'élément de liaison tubulaire (60, 70) et l'entrée (13) ou la sortie (14).

16. Ensemble de pompe selon l'une quelconque des revendications précédentes, **caractérisé en ce que** le stator (22) forme au moins une partie de la circonférence extérieure ou de la face externe de l'insert de pompe (1) et / ou délimite l'espace de réception (104).
